(19) Europäisches Patentamt
European Patent Office
Office européen des brevets

(11) **EP 3 232 212 B1**

(12) **FASCICULE DE BREVET EUROPEEN**

(45) Date de publication et mention de la délivrance du brevet:
**05.05.2021 Bulletin 2021/18**

(51) Int Cl.:
***G01R 31/12*** *(2020.01)*

(21) Numéro de dépôt: **17166158.0**

(22) Date de dépôt: **12.04.2017**

(54) **SYSTÈME ET PROCÉDÉ DE DÉTECTION D'UN ARC ÉLECTRIQUE**

SYSTEM UND VERFAHREN ZUR DETEKTION EINES LICHTBOGENS

SYSTEM AND METHOD FOR DETECTING AN ELECTRIC ARC

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.04.2016 FR 1653308**

(43) Date de publication de la demande:
**18.10.2017 Bulletin 2017/42**

(73) Titulaire: **Commissariat à l'Energie Atomique et aux Energies Alternatives
75015 Paris (FR)**

(72) Inventeurs:
• **DJIGO, Ibrahima
38700 LA TRONCHE (FR)**
• **CARMONA, Mikaël
38570 TENCIN (FR)**
• **HEIRIES, Vincent
38430 SAINT-JEAN DE MOIRANS (FR)**

(74) Mandataire: **Brevalex
56, Boulevard de l'Embouchure
B.P. 27519
31075 Toulouse Cedex 2 (FR)**

(56) Documents cités:
WO-A1-2015/100577    FR-A1- 2 944 403
FR-A1- 3 015 045    US-A1- 2006 164 097

• Si Mohamed ET AL: "Traitement des signaux parcimonieux et applications", , 20 novembre 2012 (2012-11-20), XP055327872, Extrait de l'Internet:
URL:https://hal.archives-ouvertes.fr/tel-0 0789538/document [extrait le 2016-12-09]

**Description**

**DOMAINE TECHNIQUE**

La présente invention concerne le domaine de détection d'un arc électrique et plus particulièrement, la détection d'un arc électrique à partir de sa signature acoustique.

**ÉTAT DE LA TECHNIQUE ANTÉRIEURE**

Un arc électrique peut par exemple être produit par la rupture d'un câble, par une connectique défectueuse ou lorsque deux contacts conduisant initialement un courant électrique sont séparés. L'apparition d'arcs électriques entretenus dans le temps au niveau d'éléments électriques de stockage, de distribution, de transport, ou d'utilisation peut éventuellement entraîner des dégradations de ces éléments électriques et des équipements voisins. Les arcs électriques sont particulièrement dangereux dans des installations fonctionnant en courant continu dans la mesure où l'intensité du courant reste entretenue dans le temps sans le passage par une valeur nulle. Ainsi, afin de se prémunir contre les risques de propagation d'arcs électriques, la détection précoce de leur formation est un enjeu majeur pour la sécurité et la sûreté de fonctionnement des systèmes ou installations électriques.

Diverses solutions ont été proposées pour détecter les prémices d'un arc électrique. La plupart de ces solutions sont basées sur la mesure de l'intensité électrique dans la ligne alimentant l'élément électrique. En effet, lors de l'apparition d'un arc électrique, l'intensité de courant augmente de façon significative pouvant dépasser plusieurs fois l'intensité de courant nominale. Toutefois, dans certaines installations électriques, l'intensité électrique peut être perturbée par des charges électriques en amont d'un générateur et peuvent par conséquent, fausser la détection et provoquer des fausses alarmes.

D'autres solutions prometteuses sont basées sur des mesures de signaux acoustiques sachant que ces derniers accompagnent la formation d'un arc électrique. Ces solutions utilisent de manière classique des traitements de signaux temporels et fréquentiels pour analyser le signal acoustique mesuré afin d'identifier une signature d'un arc électrique. Toutefois, ce genre de méthodes nécessite un réglage complexe d'une pluralité de paramètres et autres valeurs de seuils compliquant ainsi leur mise en œuvre. De plus, elles requièrent souvent des ressources calculatoires importantes ce qui peut être particulièrement contraignant pour par exemple, un système électrique embarqué dans un aéronef

Le document FR3015045 décrit un système de détection d'arcs électriques, comportant une enceinte définissant un volume à surveiller, et un dispositif de mesure acoustique filtrant les fréquences inférieures à 60 kHz.

L'objectif de la présente invention est par conséquent de proposer un système et un procédé de détection d'un arc électrique simple à mettre en œuvre et qui est capable de détecter avec précision et fiabilité toute apparition d'un arc électrique dans une installation électrique sans présenter les inconvénients précités.

**EXPOSÉ DE L'INVENTION**

La présente invention est définie par un système de détection d'un arc électrique dans une installation électrique équipée d'au moins un capteur adapté à détecter des signaux acoustiques temporels produits par l'installation électrique, ledit système comportant un dispositif d'analyse configuré pour analyser tout signal acoustique temporel en provenance dudit au moins un capteur en associant audit signal acoustique une mesure de parcimonie correspondante dont la valeur indique si ledit signal acoustique est une signature d'un arc électrique ou non, le dispositif d'analyse étant configuré pour déterminer ladite mesure de parcimonie en échantillonnant ledit signal acoustique pour former un signal échantillonné, en comprimant le signal échantillonné pour former un signal comprimé et en reconstruisant le signal échantillonné à partir dudit signal comprimé.

Ce système permet de détecter avec précision un arc électrique grâce à un unique paramètre qui est la parcimonie du signal acoustique minimisant ainsi les réglages et les ressources calculatoires tout en permettant une très forte discrimination entre un arc électrique et un événement parasite. On notera que le fait qu'il y ait seulement un paramètre permet au système d'être réglé très facilement contrairement à l'état de l'art où il est nécessaire de faire une pluralité de réglages de tout ordre.

Avantageusement, le dispositif d'analyse comporte :

- un circuit de prétraitement configuré pour transformer ledit signal acoustique temporel en un signal échantillonné $f$ de dimension prédéterminée N ($f \in R^N$) et exprimé dans une base temporelle,
- un processeur configuré pour déterminer la mesure de parcimonie dudit signal acoustique en calculant une probabilité de parcimonie du signal échantillonné $f$ correspondant et pour détecter un franchissement d'une valeur seuil prédéterminée par ladite probabilité de parcimonie, ledit franchissement étant représentatif de la signature d'un arc électrique.

Ceci permet de facilement distinguer entre un arc électrique et un tout autre événement, le signal acoustique étant une signature d'un arc électrique si la probabilité de parcimonie est tout simplement supérieure à ladite valeur seuil prédéterminée.

Selon un mode de réalisation de la présente invention, ledit processeur est configuré pour :

- compresser de manière itérative le signal échantillonné $f$ en le multipliant à chaque itération courante par une matrice d'acquisition $\phi$ aléatoire différente à chaque itération, formant un signal sous-échantillonné $y$ courant de dimension $M$ avec $M < N$,

- calculer, à partir du signal sous-échantillonné $y$ courant, un signal échantillonné de reconstruction $\hat{f}$ courant en cherchant une solution minimisant une norme prédéterminée $l_1$ mesurant la parcimonie du signal échantillonné,
- identifier un nombre prédéterminé $k$ de positions temporelles estimées courantes $\hat{p}_1$ ..., $\hat{p}_k$ des plus fortes amplitudes du signal échantillonné de reconstruction $\hat{f}$,
- déterminer la probabilité de parcimonie $P_L$ dudit signal échantillonné $f$ en calculant la proportion du nombre d'itérations au cours desquelles les positions temporelles estimées $\hat{p}_1,...,\hat{p}_k$ des plus fortes amplitudes du signal échantillonné de reconstruction $\hat{f}$ sont concordantes avec les vraies positions temporelles $p_1, ..., p_k$ des plus fortes amplitudes du signal échantillonné $f$,
- comparer ladite probabilité de parcimonie $P_L$ à ladite valeur seuil prédéterminée, ledit signal acoustique étant une signature d'un arc électrique si la probabilité de parcimonie $P_L$ est supérieure à ladite valeur seuil prédéterminée.

Ainsi, on mesure de manière efficace et robuste la parcimonie d'un signal échantillonné $f$ en utilisant de manière astucieuse un algorithme « d'acquisition comprimée ».

Selon une particularité de la présente invention, ledit nombre prédéterminé k est égal à un et dans ce cas ledit processeur est configuré pour :

- identifier une position temporelle estimée courante du maximum d'amplitude du signal échantillonné de reconstruction $\hat{f}$, et
- déterminer la probabilité de parcimonie $P_L$ dudit signal échantillonné $f$ en calculant la proportion du nombre d'itérations au cours desquelles chaque position temporelle estimée du maximum d'amplitude du signal échantillonné de reconstruction $\hat{f}$ est concordante avec la vraie position temporelle du maximum d'amplitude du signal échantillonné $f$.

Ceci permet de mesurer de manière précise la parcimonie d'un signal échantillonné $f$ en minimisant les étapes de calcul.

Selon un autre mode de réalisation de la présente invention, ledit processeur est en outre configuré pour exprimer le signal échantillonné $f$ avant sa compression dans une autre base orthonormée dans laquelle il est parcimonieux en utilisant une matrice de passage $\psi$ ($f = \psi x$).

Ceci permet de se placer dans une base où le signal échantillonné $f$ est parcimonieux et couvre ainsi des cas exceptionnels où le signal acoustique provoqué par un arc électrique n'est pas parcimonieux dans une base temporelle.

Avantageusement, le circuit de prétraitement comporte :

- un modulateur configuré pour former un signal acoustique modulé en modulant ledit signal acoustique selon une fréquence centrale prédéterminée et une bande de fréquence prédéterminée,
- un filtre passe-bas configuré pour former un signal acoustique filtré en opérant un filtrage passe-bas selon une fréquence de coupure prédéterminée sur ledit signal acoustique modulé, et
- un échantillonneur configuré pour échantillonner le signal acoustique filtré à une fréquence d'échantillonnage supérieure ou égale au double de la fréquence de coupure formant ainsi ledit signal échantillonné $f$.

Le circuit de prétraitement permet de drastiquement réduire la fréquence d'échantillonnage et donc la quantité de données à traiter.

Avantageusement, ledit au moins un capteur est sélectionné de manière à ce que son diagramme de gain présente un gain maximal dans la bande de fréquence prédéterminée.

Ainsi, le gain du capteur est maximal dans la bande de fréquences caractéristique d'un arc électrique.

Avantageusement, ledit modulateur est configuré pour former le signal acoustique modulé en réalisant un filtrage passe-bande sur le signal acoustique selon la bande de fréquences prédéterminée et en le multipliant par une fonction cosinus de fréquence centrale prédéterminée et de déphasage nul.

Avantageusement, la fréquence centrale prédéterminée est une valeur comprise entre 30kHz et 200kHz et de préférence égale à environ 100kHz, la bande de fréquence prédéterminée étant une valeur comprise entre 10kHz et 50kHz et de préférence égale à environ 20kHz, la fréquence de coupure étant d'environ 5kHz et la fréquence d'échantillonnage étant d'environ 10kHz. Ces valeurs sont données à titre indicatif et non limitatif.

Avantageusement, l'installation électrique comprend un ensemble d'éléments électriques équipés chacun d'un capteur spécifique permettant ainsi d'identifier l'élément électrique à l'endroit duquel l'arc électrique se produit.

L'invention vise également un procédé de détection d'un arc électrique dans une installation électrique équipée d'au moins un capteur adapté à détecter des signaux acoustiques temporels produits par l'installation électrique, ledit procédé comportant une analyse de tout signal acoustique temporel en provenance dudit au moins un capteur en associant audit signal acoustique une mesure de parcimonie correspondante dont la valeur indique si ledit signal acoustique est une signature d'un arc électrique ou non.

## BRÈVE DESCRIPTION DES DESSINS

D'autres caractéristiques et avantages de l'invention apparaîtront à la lecture de modes de réalisation préférentiels de l'invention faits en référence aux figures jointes parmi lesquelles :

La Fig. 1 illustre de manière schématique un procédé et un système de détection d'un arc électrique dans une installation électrique, selon un mode de réalisation de l'invention ;

La Fig. 2 illustre de manière schématique un système de détection, selon un mode de réalisation préféré de l'invention ;

Les Figs. 3A et 3B illustrent la réduction de la fréquence d'échantillonnage grâce aux opérations d'un circuit de prétraitement sur des signaux acoustiques issus d'un choc mécanique et d'un arc électrique, selon l'invention ;

La Fig. 4A est un organigramme illustrant un procédé de détermination de la mesure de parcimonie du signal acoustique par un processeur, selon un mode de réalisation préféré de l'invention ;

La Fig. 4B est un organigramme illustrant un procédé de détermination de la mesure de parcimonie du signal acoustique, selon un mode de réalisation particulier de celui de la Fig. 4A ;

Les Figs. 5A et 5B illustrent les signaux de reconstruction de ceux illustrés sur les Figs. 3A et 3B, selon l'invention ;

Les Figs. 6A à 8B illustrent l'application des étapes de prétraitement de la Fig. 2 et de ceux de l'organigramme de la Fig. 4 sur différents signaux acoustiques inconnus, selon l'invention ;

La Fig. 9 est un organigramme illustrant un procédé de détermination de la mesure de parcimonie du signal acoustique par le processeur, selon un autre mode de réalisation préféré de l'invention ; et

La Fig. 10 illustre de manière schématique un système de détection d'un arc électrique dans une installation électrique, selon un mode préféré de réalisation de l'invention.

## EXPOSÉ DÉTAILLÉ DE MODES DE RÉALISATION PARTICULIERS

Le concept à la base de l'invention repose uniquement sur l'analyse de la parcimonie du signal acoustique dans une base de fréquences prédéterminée.

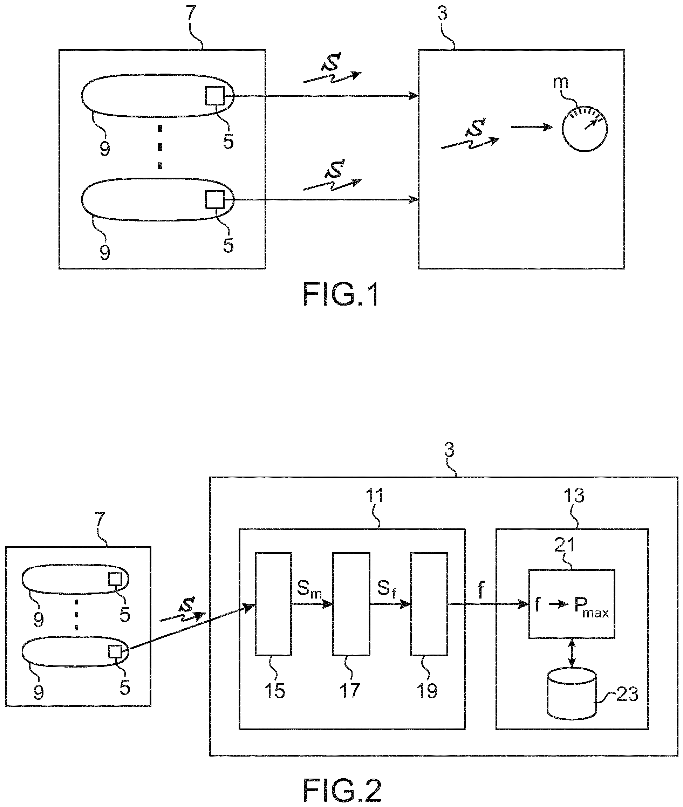

La Fig. 1 illustre de manière schématique un procédé et un système de détection d'un arc électrique dans une installation électrique, selon un mode de réalisation de l'invention.

Le système 1 de détection est mis en œuvre par un dispositif d'analyse 3 ainsi que par au moins un capteur 5 acoustique adapté à détecter des signaux acoustiques temporels produits par l'installation électrique 7.

Avantageusement, l'installation électrique 7 est équipée d'une pluralité de capteurs 5 acoustiques pour surveiller différentes parties de l'installation. En effet, l'installation électrique 7 comporte en général un ensemble d'éléments électriques 9 et chaque capteur 5 acoustique est alors disposé sur l'élément électrique 9 que l'on souhaite surveiller. Un capteur 5 acoustique peut être constitué d'un ou de plusieurs transducteurs dans une bande allant de quelques hertz à quelques centaines de kHz. Les différents capteurs 5 acoustiques sont individuellement connectés au dispositif d'analyse 3 et chaque capteur 5 acoustique est adapté pour délivrer à ce dernier un signal acoustique temporel S représentant la variation au cours du temps de l'amplitude de l'onde acoustique qu'il a captée.

Conformément à l'invention, le dispositif d'analyse 3 est configuré pour analyser tout signal acoustique temporel S en provenance du ou d'un des capteur(s) 5 en associant à chaque signal acoustique S une mesure de parcimonie m correspondante dont la valeur indique si le signal acoustique est une signature d'un arc électrique ou non.

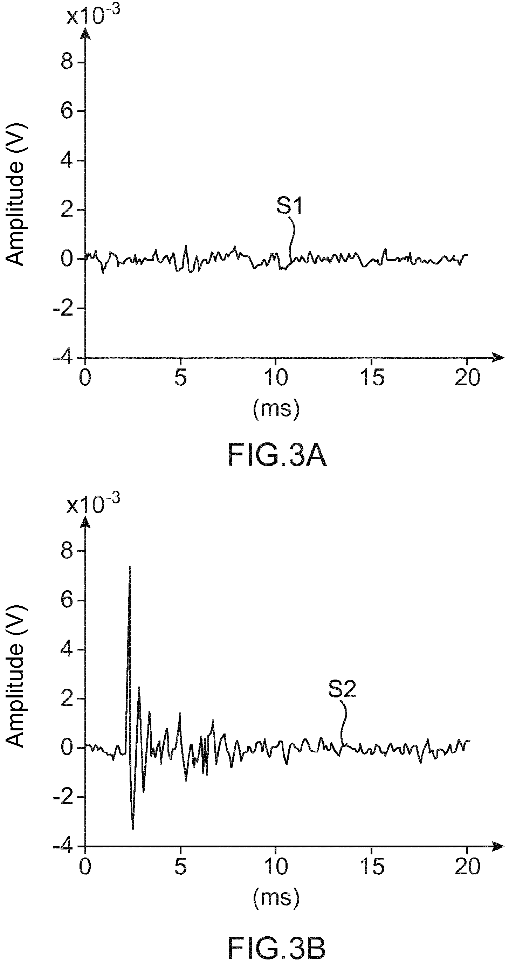

En effet, une onde acoustique S peut être émise non seulement par un arc électrique mais également par d'autres types d'événements survenant dans l'installation électrique et en particulier, par un choc mécanique sachant que ce dernier peut se produire lors d'une utilisation normale de l'installation électrique. Toutefois, une particularité d'une onde acoustique générée par un arc électrique est qu'elle peut être considérée comme étant parcimonieuse en temps dans une certaine bande de fréquence (voir Fig. 3B) tandis que celle générée par un choc mécanique ne l'est pas (voir Fig. 3A). Ainsi, en évaluant la parcimonie de chaque signal acoustique S, le dispositif d'analyse 3 est apte à discriminer avec une très grande précision entre un arc électrique et un choc mécanique ou éventuellement un tout autre événement parasite. La mesure d'un seul paramètre (i.e. la grandeur de la parcimonie du signal acoustique) permet ainsi de détecter rapidement et de manière robuste et fiable l'amorce d'un arc électrique dans l'installation électrique 7.

La Fig. 2 illustre de manière schématique un système de détection, selon un mode de réalisation préféré de l'invention.

Selon ce mode de réalisation, le dispositif d'analyse 3 comporte un circuit de prétraitement 11, et un circuit de traitement 13 de données.

Le circuit de prétraitement 11 est configuré pour transformer le signal acoustique temporel S acquis depuis un capteur 5 en un signal numérique échantillonné $f$ présentant une quantité de données réduite par rapport au signal acoustique S de départ. Ce signal numérique échantillonné $f$ correspond à un vecteur de dimension prédéterminée $N$ (i.e., $f \in R^N$) exprimé dans une base temporelle orthonormée.

Avantageusement, le circuit de prétraitement 11 comporte un modulateur 15, un filtre passe-bas 17 et un échantillonneur 19.

Le modulateur 15 est configuré pour recevoir le signal acoustique temporel S depuis le capteur 5 et pour moduler en bande de base ce signal acoustique S selon une fréquence centrale $v_0$ prédéterminée et une bande de fréquence $B$ prédéterminée. Ainsi, à sa sortie, le modulateur 15 délivre un signal acoustique modulé $S_m$.

Avantageusement, le modulateur 15 comporte un circuit analogique configuré pour réaliser un filtrage passe-bande sur le signal acoustique S selon la bande de fréquences $B$ prédéterminée tout en le multipliant par une fonction cosinus de déphasage nul et de fréquence centrale $v_0$ prédéterminée. En effet, le modulateur 15 peut comporter un circuit oscillateur sinusoïdal adapté pour faire une opération de multiplication par une fonction cosinus. Le circuit oscillateur est très stable et peut être choisi parmi un oscillateur LC de Clapp, oscillateur à résistance négative, oscillateur à réseau déphaseur, etc.

La fréquence centrale $v_0$ prédéterminée correspond avantageusement à une valeur comprise entre 30kHz et 200kHz et de préférence égale à environ 100kHz. Par ailleurs, la bande de fréquence $B$ prédéterminée est avantageusement une valeur comprise entre 10kHz et 50kHz et de préférence égale à environ 20kHz.

La fréquence centrale $v_0$ et la bande de fréquence $B$ sont choisies dans un domaine caractéristique des arcs électriques et dans lequel le signal acoustique S issu d'un arc électrique est particulièrement parcimonieux en temps tandis qu'un signal acoustique S issu d'un choc mécanique ne l'est pas. La bande de fréquence $B$ est sélectionnée autour d'une fréquence centrale $v_0$ suffisamment haute (i.e. supérieure à 10kHz) pour ne pas être perturbée par des parasites de basses fréquences tout en restant pas très haute (i.e. inférieure à 200kHz) pour éviter l'atténuation du signal. La modulation permet ainsi de minimiser la fréquence d'échantillonnage tout en se focalisant sur une bande de fréquences caractéristique des arcs électriques.

En outre, chaque capteur 5 acoustique est avantageusement sélectionné de manière à ce que son diagramme de gain présente un gain maximal dans la bande de fréquence $B$ prédéterminée de sorte que la réponse du capteur 5 acoustique est optimale et les parasites sont peu présents dans cette bande $B$.

Le filtre passe-bas 17 comporte avantageusement un circuit analogique configuré pour opérer un filtrage passe-bas selon une fréquence de coupure $v_c$ prédéterminée, sur le signal acoustique modulé $S_m$ reçu depuis le modulateur 15. A sa sortie, le filtre passe-bas 17 délivre un signal acoustique modulé et filtré $S_f$ (appelé dans la suite, signal acoustique filtré). La fréquence de coupure $v_c$ est liée à la bande de fréquence sélectionnée et peut être égale à environ 5kHz. Le filtrage permet de nettoyer encore davantage le signal des éventuels parasites pouvant être gênants en dehors de la fréquence de coupure $v_c$.

Le filtrage passe-bas peut être réalisé avec un simple filtre de Butterworth d'ordre 2. Avantageusement, ce type de filtre présente un gain assez plat dans sa bande passante. De plus, il est très facile à réaliser avec un amplificateur opérationnel, deux résistances identiques et deux capacités (non représentés). En outre, l'atténuation du signal à filtrer est déjà assez importante juste après la fréquence de 5kHz, ce qui permet de retrouver l'information basse fréquence souhaitée même avec un filtre de très petit ordre.

Avantageusement, l'utilisation par le circuit de prétraitement 11 d'une chaîne de circuits analogiques (i.e. modulateur 15 et filtre passe-bas 17) permet de minimiser la quantité de données à traiter numériquement.

Par ailleurs, l'échantillonneur 19 est configuré pour échantillonner le signal acoustique filtré $S_f$ reçu depuis le filtre passe-bas 17 selon une fréquence d'échantillonnage $v_e$ supérieure ou égale au double de la fréquence de coupure $v_c$. A sa sortie, l'échantillonneur 19 délivre le signal numérique échantillonné $f$. La fréquence d'échantillonnage $v_e$ est choisie en fonction de la fréquence de coupure $v_c$ tout en respectant la contrainte de Shannon afin d'éviter le repliement du spectre. A titre d'exemple, la fréquence d'échantillonnage est le double de la fréquence de coupure ($v_e = 2 \times v_c$). Ainsi, pour une fréquence de coupure $v_c = 5kHz$, la fréquence d'échantillonnage $v_e = 10kHz$. Avantageusement, l'échantillonneur 19 comporte un convertisseur analogique-numérique et un filtre anti-repliement (anti-aliasing) pour éviter le repliement du spectre avant l'échantillonnage à 10kHz.

On notera qu'une émission acoustique d'un arc électrique de 500kHz nécessiterait une fréquence d'échantillonnage colossale de 1 MHz si l'on souhaite respecter le théorème de Shannon. Toutefois, les opérations selon l'invention de filtrage passe-bande, translation en bande de base et filtrage passe-bas à environ 5 kHz permettent de réduire la fréquence d'échantillonnage de 1MHz à seulement 10kHz représentant ainsi, une réduction de la quantité de données à traiter d'un facteur 100.

En effet, les exemples des Figs. 3A et 3B illustrent bien la réduction de la fréquence d'échantillonnage grâce aux opérations du circuit de prétraitement sur des signaux acoustiques S1 et S2 issus d'un choc mécanique (Fig. 3A) et d'un arc électrique (Fig. 3B).

On remarque également que sur la Fig. 3A, le signal acoustique S1 issu d'un choc mécanique présente une structure de bruit, tandis que sur la Fig. 3B, le signal acoustique S2 issu d'un arc électrique présente une structure quasi-parcimonieuse en temps. En effet, le signal acoustique S2 de la Fig. 3B montre quatre coefficients (ou pics) ayant des amplitudes supérieures à celles des autres coefficients.

Par ailleurs, le circuit de traitement 13 de données comprend un processeur 21 et des moyens de stockage 23. Ces derniers comportent un programme d'ordinateur susceptible d'être exécuté par le processeur 21 et comprenant des instructions de code adaptées à la mise en œuvre d'un procédé de mesure de parcimonie dans des signaux acoustiques S pour détecter des éventuels arcs électriques selon l'invention.

En effet, le processeur 21 est configuré pour déterminer la mesure de parcimonie du signal acoustique S en calculant une probabilité de parcimonie $P_{Lmax}$ du signal échantillonné $f$ correspondant. En outre, le processeur 21 est configuré pour détecter un franchissement d'une valeur seuil prédéterminée par la probabilité de parcimonie $P_{Lmax}$ sachant que le franchissement de la valeur seuil est représentatif de la signature d'un arc électrique. Ainsi, la valeur de la probabilité de parcimonie du signal échantillonné $f$ permet de facilement distinguer un signal acoustique issu d'un arc électrique d'un autre signal acoustique issu d'un choc mécanique.

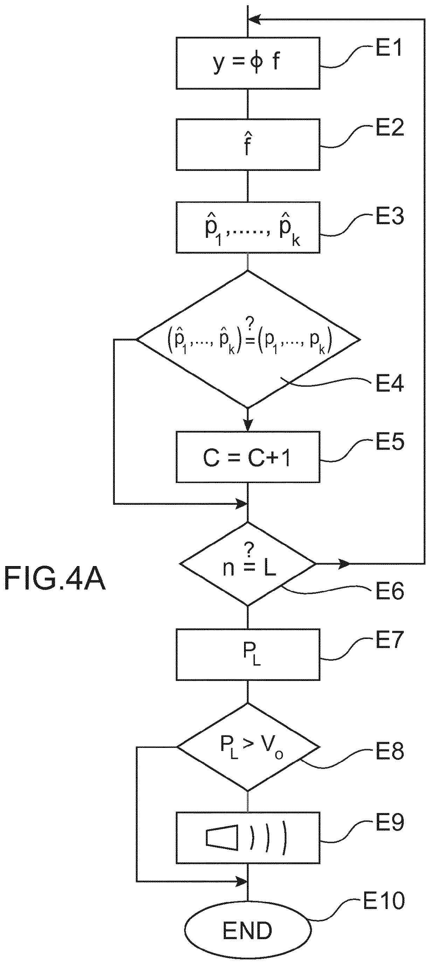

La Fig. 4A est un organigramme illustrant un procédé de détermination de la mesure de parcimonie du signal acoustique par le processeur, selon un mode de réalisation préféré de l'invention.

Les étapes E1 à E6 forment une boucle itérative réalisée un nombre $L$ prédéterminé de fois. En particulier, ces étapes appliquent astucieusement un algorithme « d'acquisition comprimée » (compressive sensing, en anglais) sur le signal échantillonné $f$ pour déterminer la parcimonie de ce signal. La technique d'acquisition comprimée stipule que si un signal $f$ est à l'origine parcimonieux, alors il est possible de reconstruire ce signal $f$ à partir d'un petit nombre d'acquisitions. Ici, la technique d'acquisition comprimée est utilisée de manière détournée de son but principal c'est-à-dire, non pas dans le but de reconstruire un signal mais plutôt pour mesurer la parcimonie de ce signal. Ainsi, les étapes selon cet organigramme consistent d'abord à comprimer le signal échantillonné $f$ et puis à le reconstruire à partir du signal comprimé afin de voir si le signal reconstruit concorde ou correspond bien avec le signal échantillonné $f$ d'origine, sachant qu'une bonne concordance entre les deux signaux est un indicateur de la parcimonie du signal échantillonné $f$ d'origine.

En effet, à chaque itération des étapes E1 et E2, le signal échantillonné $f$ reçu depuis le circuit de prétraitement 11 est sous-échantillonné avant d'être reconstruit selon la technique d'acquisition comprimée.

Plus particulièrement, à l'étape E1, le processeur 21 est configuré pour compresser de manière itérative le signal échantillonné $f$ (appartenant à $R^N$) suivant un nombre d'itérations $L$ prédéterminé. La compression est réalisée en multipliant à chaque itération courante n, le signal échantillonné $f$ par une matrice d'acquisition $\phi$ aléatoire (i.e. générée aléatoirement à chaque itération). Autrement dit, on effectue le produit scalaire du signal échantillonné $f$ par $M$ formes d'ondes $\{\varnothing_k\}_{k=1\cdots M}$ ce qui

donne $M$ mesures notées $y_k = \langle f, \varnothing_k \rangle$, $k = 1 \ldots M$ avec $M < N$. On notera que la matrice d'acquisition $\phi$ est différente à chaque itération du fait qu'elle est générée aléatoirement à chaque itération.

Ainsi, à l'étape E1, la compression du signal échantillonné $f$ forme à chaque itération courante n, un signal sous-échantillonné $y$ courant de dimension $M$ (i.e.

$$T_c = \frac{N}{M} \text{).}$$

avec un taux de compression Le signal sous-échantillonné $y$ est ainsi la corrélation du signal échantillonné $f$ avec les formes d'ondes $\{\varnothing_k\}_{k=1\cdots M}$. Si ces formes d'ondes sont par exemple, des impulsions de Dirac en temps, alors le signal $y$ est une version échantillonnée du signal $f$ dans le domaine temporel.

Le signal sous-échantillonné $y = (y_1, y_2, \ldots, y_M)$ peut ainsi s'écrire sous la forme $y = \phi f$ où la matrice d'acquisition $\phi$ (de dimension $M \times N$) est générée aléatoirement à chaque itération selon une loi à réalisation aléatoire (par exemple de type bernoulli, gaussienne, uniforme, etc.). A titre d'exemple, les valeurs des coefficients de la matrice d'acquisition $\phi$ peuvent être générées de manière aléatoire à partir de seulement deux valeurs (par exemple, +1 et -1).

A l'étape E2, le processeur 21 est configuré pour calculer à chaque itération courante les coefficients d'un signal échantillonné de reconstruction $\hat{f}$ courant en connaissant le signal sous-échantillonné $y$ et la matrice d'acquisition $\phi$ courants. Il s'agit ainsi de résoudre un système sous-déterminé de $M$ équations à $N$ inconnues pour retrouver une estimation du signal échantillonné $f$ de départ.

La technique d'acquisition comprimée stipule que si un signal $f$ est parcimonieux d'ordre $S$ dans une base orthonormée alors, il est possible de reconstruire exactement le signal $f$. Plus particulièrement, si le signal échantillonné $f$ de $R^N$ est quasiment nul en tout point sauf en $S$ valeurs, avec $S \ll N$, alors on peut calculer les coefficients d'un signal échantillonné de reconstruction $\hat{f}$, sous la condition suivante :

$$M \geq M_{min} = C_\phi . S \log \frac{N}{S}$$

où $C_\phi$ est une constante dépendante de la matrice d'acquisition $\phi$ choisie. On notera que les valeurs des coefficients de la matrice d'acquisition $\phi$ peuvent être choisies aléatoirement, tant que la condition ci-dessus est respectée.

Alors, en connaissant le signal sous-échantillonné $y$ et la matrice d'acquisition $\phi$ courants, le signal échantillonné de reconstruction $\hat{f}$ peut être calculé en cherchant une solution minimisant une norme prédéterminée $l_1$ mesurant la parcimonie du signal échantillonné $f$. Ceci revient à utiliser des méthodes connues de minimisation de la norme $l_1$ pour chercher la solution de l'équation suivante :

$$\hat{f} = \underset{f}{\mathrm{argmin}}\|f\|_1 \; tel\ que\ y = \phi f.$$

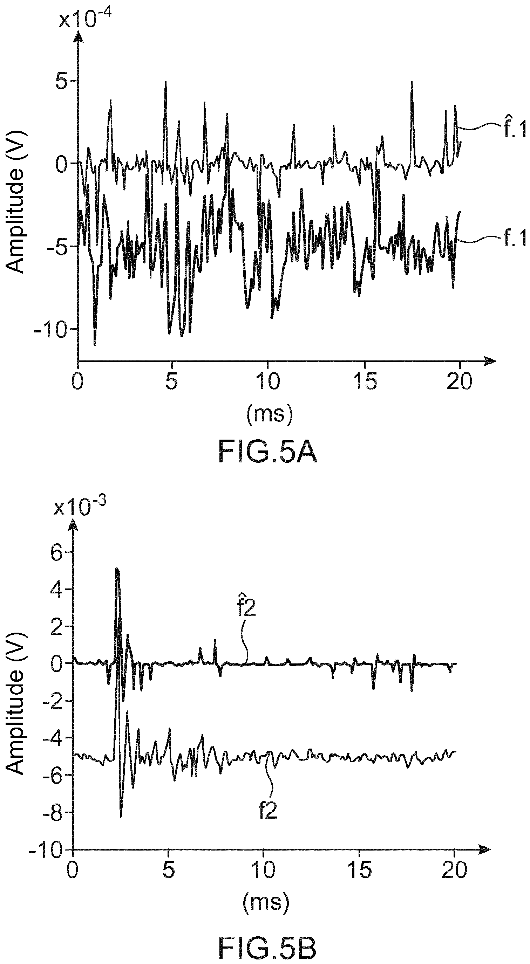

Les Figs. 5A et 5B illustrent les signaux de reconstruction de ceux illustrés sur les Figs. 3A et 3B. Ces courbes illustrent une reconstruction de chacun des signaux acoustique S1 et S2 issus des signaux de choc mécanique et d'arc électrique avec un taux de compression $T_c$ = 4. Plus particulièrement, la Fig. 5A illustre le signal échantillonné $f1$ du signal acoustique S1 (de la Fig. 3A) ainsi que le signal échantillonné de reconstruction $\hat{f}1$. La Fig. 5B illustre le signal échantillonné $f2$ du signal acoustique S2 (de la Fig. 3B) ainsi que le signal échantillonné de reconstruction $\hat{f}2$. On voit bien qu'avec seulement un taux de compression de $T_c$ = 4, les pics principaux du signal $\hat{f}2$ issu d'un arc électrique ont été reconstruits, ce qui n'est pas le cas pour le signal $\hat{f}1$ issu d'un choc mécanique.

Une fois que les coefficients du signal échantillonné de reconstruction $\hat{f}$ ont été calculés, les étapes E3 à E8 consistent à vérifier la concordance de ce signal $\hat{f}$ avec le signal échantillonné $f$ d'origine. Ceci consiste à comparer la position temporelle d'un ou de plusieurs pic(s) spécifique(s) du signal échantillonné de reconstruction $\hat{f}$ avec celle(s) d'un ou de plusieurs pic(s) correspondant(s) du signal échantillonné $f$. En effet, à l'étape E3, le processeur 21 est configuré pour identifier un nombre prédéterminé k de positions temporelles estimées courantes $\hat{p}_1,...,\hat{p}_k$ indexant les plus fortes amplitudes du signal échantillonné de reconstruction $\hat{f}$. Le nombre prédéterminé $k$ peut par exemple être compris entre 1 et 10.

L'étape E4 est un test où le processeur 21 est configuré pour comparer ces positions temporelles estimées $\hat{p}_1...,\hat{p}_k$ des plus fortes amplitudes du signal échantillonné de reconstruction $\hat{f}$ aux positions temporelles réelles $p_1,...,p_k$ des plus fortes amplitudes du signal échantillonné $f$ d'origine. Si les positions sont identiques, on passe à l'étape E5 et sinon, on passe directement à l'étape E6.

A l'étape E5, le processeur 21 est configuré pour incrémenter d'une unité un compteur de concordance C initialisé à zéro. Ainsi, à chaque fois que les positions estimées $\hat{p}_1,...,\hat{p}_k$ sont les mêmes que les positions réelles $p_1,...,p_k$, le compteur C est incrémenté.

L'étape E6 est un test pour savoir si l'itération courante n a atteint le nombre d'itérations L prédéterminé. Si oui, on passe à l'étape E7 et sinon, on reboucle à l'étape E1.

A l'étape E7, le processeur 21 est configuré pour déterminer la probabilité de parcimonie $P_L$ du signal échantillonné $f$ en calculant le quotient (ou un taux de concordance) entre la valeur du compteur de concordance C et le nombre total d'itérations L (i.e. le nombre total de reconstructions effectuées). Ainsi, la probabilité de parcimonie $P_L$ est définie par une mesure de congruence représentant la proportion du nombre d'itérations au cours desquelles les positions temporelles estimées $\hat{p}_1,...,\hat{p}_k$ sont concordantes avec les vraies positions temporelles $p_1,...,p_k$ des plus fortes amplitudes du signal échantillonné $f$. Avantageusement, le fait de réaliser la compression et la reconstruction un certain nombre de fois permet de moyenner l'erreur et par conséquent, d'améliorer la précision de la probabilité de parcimonie $P_L$.

On notera que pour un taux de compression donné, plus un signal est parcimonieux, plus il est facile de le reconstruire avec exactitude et à l'inverse moins il est parcimonieux, plus difficile est sa reconstruction. Donc, la comparaison entre les positions temporelles estimées et les positions temporelles réelles de quelques pics (par exemple ceux qui présentent les amplitudes les plus élevées) du signal échantillonné $f$ permet de discriminer de manière robuste et précise entre un signal acoustique généré par un arc électrique et un autre signal généré par un choc mécanique ou un tout autre événement parasite.

L'étape E8 est un test où le processeur 21 est configuré pour comparer la probabilité de parcimonie $P_L$ à la valeur seuil $V_0$ prédéterminée. Si la probabilité de parcimonie $P_L$ est supérieure à ladite valeur seuil $V_0$ prédéterminée, on passe à l'étape E9 et sinon, on passe à l'étape E10.

A l'étape E9, le processeur 21 est configuré pour déclencher une alerte indiquant que le signal acoustique détecté est une signature d'un arc électrique car la probabilité de parcimonie $P_L$ a franchi la valeur seuil $V_0$ prédéterminée. A titre d'exemple, la valeur seuil $V_0$ prédéterminée peut être choisie égale à 50%.

L'étape E10 met fin à l'analyse du signal acoustique S reçu depuis le circuit de prétraitement 11.

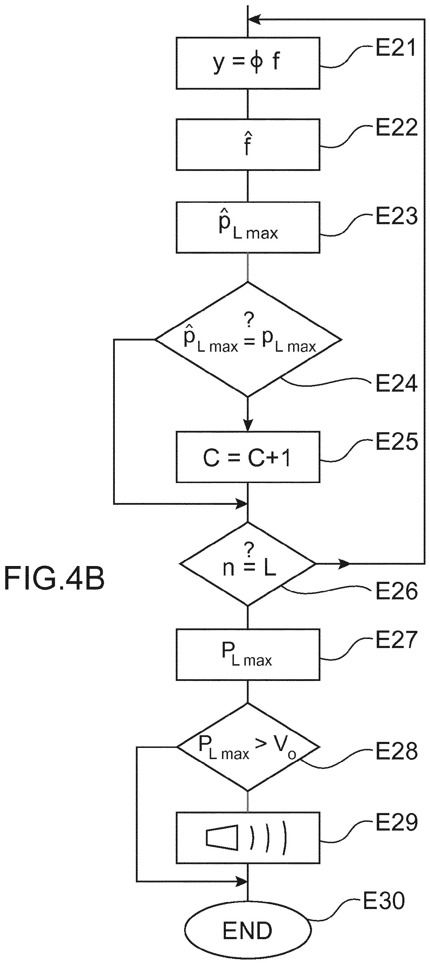

La Fig. 4B est un organigramme illustrant un procédé de détermination de la mesure de parcimonie du signal acoustique par le processeur, selon un mode de réalisation particulier de celui de la Fig. 4A.

L'organigramme de la Fig. 4B se distingue de celui de la Fig. 4A uniquement par le fait qu'on sélectionne un nombre prédéterminé k de positions temporelles égal à un. Autrement dit, on réalise une comparaison entre la position temporelle estimée et la position temporelle réelle d'un seul pic (par exemple celui qui présente le maximum d'amplitude) du signal échantillonné $f$. Cette comparaison est suffisante pour discriminer de manière précise entre un signal acoustique généré par un arc électrique et un autre signal généré par un choc mécanique.

Les étapes E21 et E22 sont identiques aux étapes E1 et E2 de la Fig. 4A respectivement.

A l'étape E23, le processeur 21 est configuré pour identifier la position temporelle estimée courante $\hat{p}_{Lmax}$ du maximum d'amplitude du signal échantillonné de reconstruction $\hat{f}$.

A l'étape E24, le processeur 21 est configuré pour comparer cette position temporelle estimée (courante) $\hat{p}_{Lmax}$ du maximum d'amplitude du signal échantillonné de reconstruction $\hat{f}$ à la position temporelle réelle

$p_{Lmax}$ du maximum d'amplitude du signal échantillonné *f* d'origine. Comme précédemment, si les positions sont identiques, on passe à l'étape E25 et sinon, on passe directement à l'étape E26.

Les étapes E25 à E30 sont quasiment identiques aux étapes E5 à E10 respectivement de la Fig. 4A.

En effet, à l'étape E25, à chaque fois que la position estimée $\hat{p}_{max}$ est la même que la position réelle $p_{max}$, le compteur de concordance C est incrémenté.

L'étape E26 est le test pour savoir si l'itération courante *n* a atteint le nombre d'itérations L prédéterminé.

A l'étape E27, le processeur 21 est configuré pour déterminer la probabilité de parcimonie $P_L$ du signal échantillonné *f* en calculant comme précédemment le quotient entre la valeur du compteur de concordance C et le nombre total d'itérations *L*. Ici, la probabilité de parcimonie $P_L$ correspond à la proportion du nombre d'itérations au cours desquelles chaque position temporelle estimée $\hat{p}_{max}$ est concordante avec la vraie position temporelle $p_{max}$ du maximum d'amplitude.

Les étapes E28 à E30 sont identiques aux étapes E8 à E10 de la Fig. 4A, respectivement.

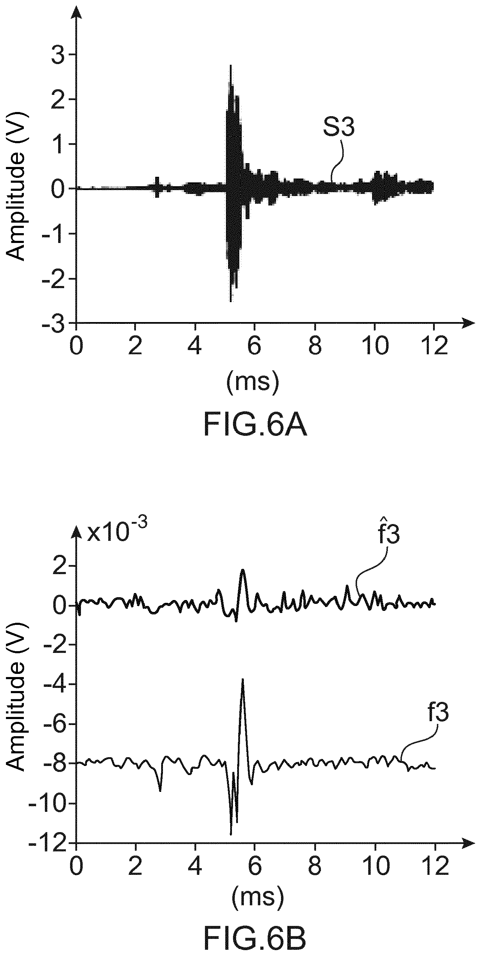

Les Figs. 6A à 8B sont des exemples illustrant l'application des étapes de prétraitement de la Fig. 2 et de ceux de l'organigramme de la Fig. 4A sur différents signaux acoustiques inconnus.

Plus particulièrement, la Fig. 6A illustre un signal acoustique S3 inconnu à discriminer. La Fig. 6B illustre un signal échantillonné *f3* résultant des étapes de prétraitement (filtrage passe-bande, translation en bande de base et filtrage passe-bas) ainsi qu'un signal échantillonné de reconstruction $\hat{f3}$ résultant des étapes de l'organigramme ci-dessus. Le résultat de l'analyse itérative sur le signal échantillonné *f3* montre que ce signal est parcimonieux avec une probabilité de parcimonie (ou de congruence) $P_L$ égale à 92% qui est bien supérieure à 50% (la valeur seuil $V_0$). Ceci conduit à conclure avec fiabilité que le signal acoustique inconnu S3 est une signature d'un arc électrique.

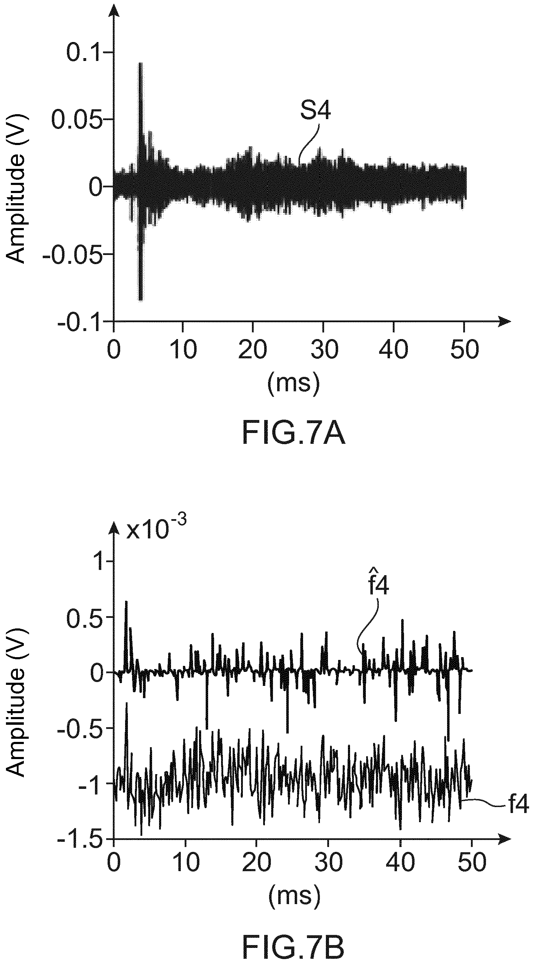

L'exemple de la Fig. 7A illustre un autre signal acoustique S4 inconnu à discriminer. La Fig. 7B illustre un signal échantillonné *f4* résultant des étapes de prétraitement sur le signal acoustique S4 ainsi qu'un signal échantillonné de reconstruction $\hat{f4}$ résultant des étapes de l'organigramme sur le signal échantillonné *f4*. Le résultat de l'analyse montre que la probabilité de parcimonie (ou de congruence) $P_L$ du signal échantillonné *f4* est égale à 7% qui est bien inférieure à 50% (la valeur seuil). Ceci conduit à conclure avec fiabilité que le signal acoustique inconnu S4 n'est pas une signature d'un arc électrique mais plutôt la signature d'un choc mécanique.

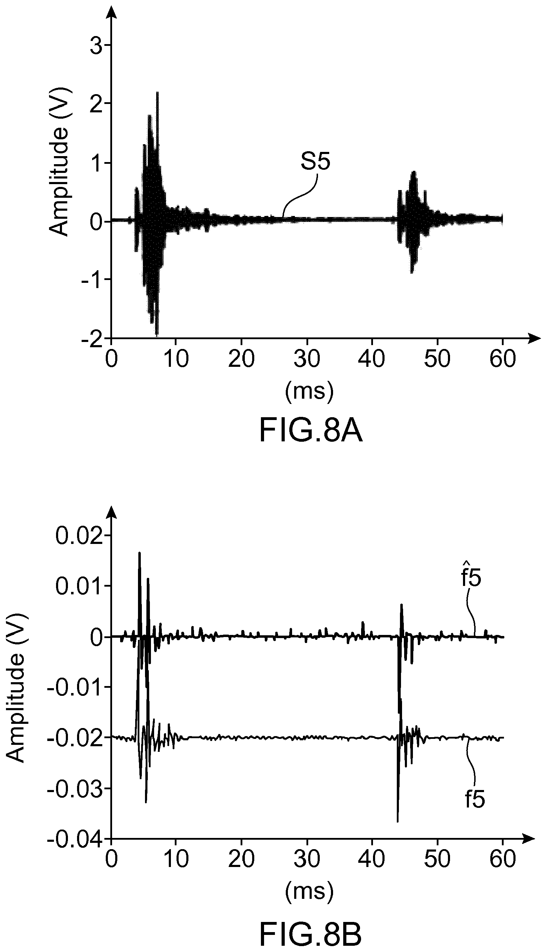

L'exemple de la Fig. 8A illustre un dernier signal acoustique S5 inconnu à discriminer. La Fig. 8B illustre un signal échantillonné *f5* résultant des étapes de prétraitement sur le signal acoustique S5 ainsi qu'un signal échantillonné de reconstruction $\hat{f5}$ résultant des étapes de l'organigramme sur le signal échantillonné *f5*. Le résultat de l'analyse montre que le signal échantillonné *f5* est parcimonieux avec une probabilité de parcimonie (ou de congruence) $P_L$ égale à 75% qui est supérieure à 50% (la valeur seuil). Ceci conduit à conclure avec fiabilité que le signal acoustique inconnu S5 est une signature d'un arc électrique ou plus précisément, la signature de deux arcs électriques successifs.

Les inventeurs ont constaté que la probabilité de parcimonie (ou de congruence) $P_L$ ne dépasse jamais 20% pour les chocs mécaniques et reste supérieure à 50% pour les arcs électriques même dans le cas d'une succession d'arcs électriques (Figs. 8A et 8B). La valeur seuil $V_0$ = 50% est ainsi particulièrement robuste.

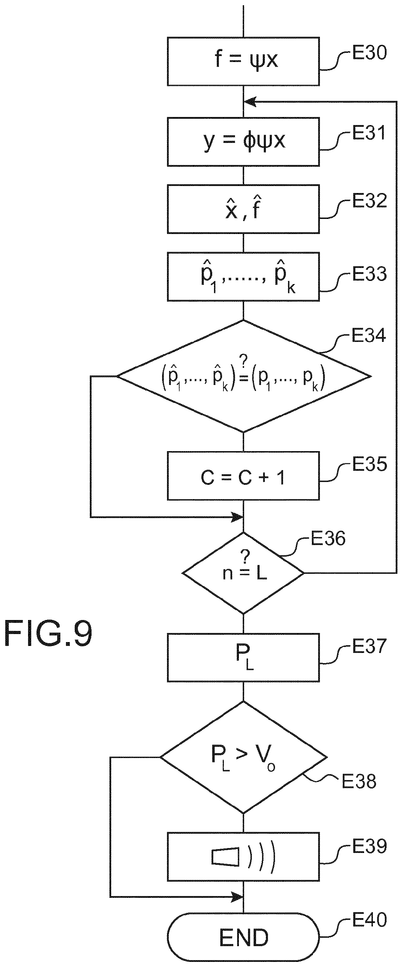

La Fig. 9 est un organigramme illustrant un procédé de détermination de la mesure de parcimonie du signal acoustique par le processeur, selon un autre mode de réalisation préféré de l'invention.

L'organigramme de la Fig. 9 se distingue de celui de la Fig. 4A uniquement par le fait qu'il comporte une étape supplémentaire E30 sachant que les étapes E31 à E40 sont quasiment identiques aux étapes E1 à E10 de la Fig. 4A.

L'étape supplémentaire E30 est destinée à permettre à un signal échantillonné *f* non parcimonieux en temps (malgré le fait qu'il soit provoqué par un évènement d'arcs électriques), de se placer dans une base où ce signal *f* peut être exprimé de manière parcimonieuse. Ce cas très peu courant peut par exemple être dû à une succession très rapprochée d'arcs électriques.

En effet, à l'étape E30, le processeur 21 est configuré pour exprimer le signal échantillonné *f* temporel dans une autre base orthonormée (par exemple, base fréquentielle, base d'ondelettes, etc.) dans laquelle il est parcimonieux en utilisant une matrice de passage $\psi$ ($f = \psi x$). Cette matrice de passage $\psi$ définit les coefficients du signal échantillonné *f* en fonction des coefficients d'un signal ou vecteur parcimonieux *x* correspondant. Autrement dit, la matrice de passage $\psi$ est choisie telle que la majorité des coefficients du vecteur *x* soient nuls dans la nouvelle base.

A l'étape E31, le processeur 21 est configuré pour compresser de manière itérative (pour un nombre d'itérations *L* prédéterminé) le signal échantillonné *f* de $R^N$ (exprimé en fonction du vecteur parcimonieux *x*) en le multipliant à chaque itération par une matrice d'acquisition $\phi$ aléatoire générant ainsi à chaque itération courante un signal sous-échantillonné *y* courant de dimension M (avec M < N) associé à un vecteur parcimonieux *x* correspondant (i.e., $y = \phi \psi x$).

A l'étape E32, le processeur 21 est configuré pour calculer à chaque itération courante les coefficients d'un vecteur de reconstruction $\hat{x}$ courant correspondant au vecteur parcimonieux *x* en cherchant une solution de l'équation suivante :

$$\hat{x} = \underset{x}{\mathrm{argmin}} \|x\|_1 \; tel \; que \; y = \phi \psi x.$$

En outre, grâce à la matrice de passage $\psi$, le processeur 21 est configuré pour calculer un signal échantillonné de reconstruction $\hat{f}$ avec $\hat{f} = \psi\hat{x}$.

Les étapes E33 à E40 sont identiques aux étapes E3 à E10 de la Fig. 4A (ou éventuellement, aux étapes E23 à E20 de la Fig. 4B). On notera que le procédé de la Fig. 4A peut être considéré comme un cas particulier de celui de la Fig. 9 dans lequel la matrice de passage $\psi$ est une application identité $I_d$ et où le vecteur $x$ est identique au signal échantillonné $f$. En effet, un signal acoustique provoqué par un arc électrique est quasi-parcimonieux dans la base temporelle dans laquelle il est acquis et par conséquent, il n'est quasiment pas nécessaire de projeter ce signal dans une autre base avant sa compression (comme proposé par le mode de réalisation de la Fig. 4A).

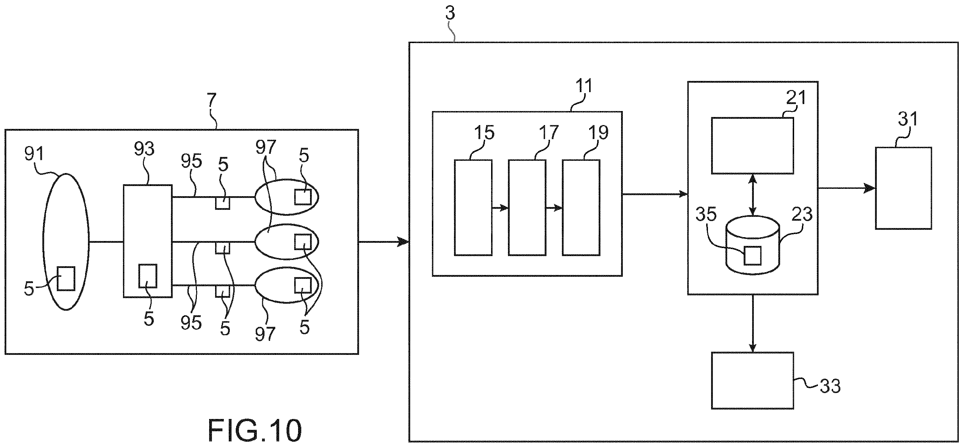

La Fig. 10 illustre de manière schématique un système de détection d'un arc électrique dans une installation électrique, selon un mode préféré de réalisation de l'invention.

L'installation électrique 7 est par exemple un système d'alimentation électrique composé d'un ensemble d'éléments comportant un générateur électrique 91, une armoire de distribution 93, des câbles électriques 95 ainsi que d'autres éléments de connexion et des équipements électriques 97. Il est en outre équipé d'un ensemble de capteurs 5 acoustiques chacun étant disposé sur un élément spécifique.

A titre d'exemple, le système d'alimentation électrique peut être un système embarqué dans un aéronef. Par ailleurs, il peut être un système d'alimentation en courant continu ou alternatif.

Le dispositif d'analyse 3 comporte un circuit de prétraitement 11, un circuit de traitement 13 de données, une interface de sortie 31 et éventuellement un module de sécurité 33. Le circuit de prétraitement 11 est configuré pour transformer chaque signal acoustique temporel détecté par un des capteurs en un signal échantillonné $f$ exprimé dans une base temporelle, comme exposé ci-dessus en référence à la Fig. 2.

Le circuit de traitement 13 de données comporte un processeur 21 et des moyens de stockage 23. Le processeur 21 est configuré pour calculer la probabilité de parcimonie de chaque signal échantillonné $f$ et pour détecter les signatures d'arcs électriques comme exposé ci-dessus en référence aux figures précédentes. Lorsqu'un arc électrique est détecté, le processeur 21 envoie un signal de détection à l'interface de sortie 31 ainsi qu'éventuellement au module de sécurité 33.

L'interface de sortie 31 est adaptée pour déclencher une alarme sonore et/ou visuelle ou pour afficher une information sur un écran. Par ailleurs, le module de sécurité 33 peut être adapté pour isoler électriquement l'élément défectueux ou pour diminuer la puissance électrique ou pour déclencher une toute autre action en fonction de l'élément affecté et du type de l'application.

Avantageusement, les moyens de stockage 23 comportent un tableau de correspondance 35 entre un premier ensemble d'identifiants des capteurs 5 acoustiques et un deuxième ensemble d'identifiants des éléments électriques 91, 93, 95, 97 associés aux capteurs. Le dispositif d'analyse 3 est ainsi adapté grâce à ce tableau de correspondance 35 pour identifier l'élément électrique à l'endroit duquel l'arc électrique se produit.

En effet, chacun des organigrammes des Figs. 4A, 4B et 9 peut avantageusement comporter une étape supplémentaire d'identification après l'étape de détection d'un arc électrique. Cette étape permet d'identifier l'élément électrique générant l'arc électrique grâce à l'identifiant du capteur qui a détecté cet arc et l'identifiant de l'élément associé au capteur selon le tableau de correspondance 35.

**Revendications**

1. Système de détection d'un arc électrique dans une installation électrique (7) équipée d'au moins un capteur (5) adapté à détecter des signaux acoustiques temporels produits par l'installation électrique (7), ledit système étant **caractérisé en ce qu'**il comporte un dispositif d'analyse (3) configuré pour analyser tout signal acoustique (S) temporel en provenance dudit au moins un capteur (5) en associant audit signal acoustique une mesure de parcimonie (m) correspondante dont la valeur indique si ledit signal acoustique est une signature d'un arc électrique ou non, le dispositif d'analyse étant configuré pour déterminer ladite mesure de parcimonie en échantillonnant ledit signal acoustique pour former un signal échantillonné, en comprimant le signal échantillonné pour former un signal comprimé et en reconstruisant le signal échantillonné à partir dudit signal comprimé.

2. Système de détection selon la revendication 1, **caractérisé en ce que** le dispositif d'analyse (3) comporte :

   - un circuit de prétraitement (11) configuré pour transformer ledit signal acoustique (S) temporel en un signal échantillonné $f$ de dimension prédéterminée N et exprimé dans une base temporelle,
   - un processeur (21) configuré pour déterminer la mesure de parcimonie dudit signal acoustique en calculant une probabilité de parcimonie du signal échantillonné $f$ correspondant et pour détecter un franchissement d'une valeur seuil prédéterminée par ladite probabilité de parcimonie, ledit franchissement étant représentatif de la signature d'un arc électrique.

3. Système de détection selon la revendication 2, **caractérisé en ce que** ledit processeur (21) est configuré pour :

- compresser de manière itérative le signal échantillonné $f$ en le multipliant à chaque itération courante par une matrice d'acquisition $\phi$ aléatoire différente à chaque itération, formant un signal sous-échantillonné $y$ courant de dimension $M$ avec $M < N$,

- calculer, à partir du signal sous-échantillonné $y$ courant, un signal échantillonné de reconstruction $\hat{f}$ courant en cherchant une solution minimisant une norme prédéterminée $l_1$ mesurant la parcimonie du signal échantillonné ,

- identifier un nombre prédéterminé $k$ de positions temporelles estimées courantes $\hat{p}_1,...,\hat{p}_k$ des plus fortes amplitudes du signal échantillonné de reconstruction $\hat{f}$,

- déterminer la probabilité de parcimonie $P_L$ dudit signal échantillonné $f$ en calculant la proportion du nombre d'itérations au cours desquelles les positions temporelles estimées $\hat{p}_1,...,\hat{p}_k$ des plus fortes amplitudes du signal échantillonné de reconstruction $\hat{f}$ sont concordantes avec les vraies positions temporelles $p_1,...,p_k$ des plus fortes amplitudes du signal échantillonné $f$,

- comparer ladite probabilité de parcimonie $P_L$ à ladite valeur seuil prédéterminée, ledit signal acoustique étant une signature d'un arc électrique si la probabilité de parcimonie $P_L$ est supérieure à ladite valeur seuil prédéterminée.

4. Système de détection selon la revendication 3, **caractérisé en ce que** ledit nombre prédéterminé $k$ est égal à un et **en ce que** ledit processeur (21) est configuré pour :

  - identifier une position temporelle estimée courante du maximum d'amplitude du signal échantillonné de reconstruction $\hat{f}$, et
  - déterminer la probabilité de parcimonie $P_L$ dudit signal échantillonné $f$ en calculant la proportion du nombre d'itérations au cours desquelles chaque position temporelle estimée du maximum d'amplitude du signal échantillonné de reconstruction $\hat{f}$ est concordante avec la vraie position temporelle du maximum d'amplitude du signal échantillonné $f$.

5. Système de détection selon la revendication 3 ou 4, **caractérisé en ce que** ledit processeur (21) est en outre configuré pour exprimer le signal échantillonné $f$ avant sa compression dans une autre base orthonormée dans laquelle il est parcimonieux en utilisant une matrice de passage $\psi$.

6. Système de détection selon l'une quelconque des revendications 2 à 5, **caractérisé en ce que** le circuit de prétraitement (11) comporte :

  - un modulateur (15) configuré pour former un signal acoustique modulé en modulant ledit signal acoustique selon une fréquence centrale prédéterminée et une bande de fréquence prédéterminée,
  - un filtre passe-bas (17) configuré pour former un signal acoustique filtré en opérant un filtrage passe-bas selon une fréquence de coupure prédéterminée sur ledit signal acoustique modulé, et
  - un échantillonneur (19) configuré pour échantillonner le signal acoustique filtré à une fréquence d'échantillonnage supérieure ou égale au double de la fréquence de coupure formant ainsi ledit signal échantillonné $f$.

7. Système de détection selon la revendication 6, **caractérisé en ce que** ledit au moins un capteur (5) est sélectionné de manière à ce que son diagramme de gain présente un gain maximal dans la bande de fréquence prédéterminée.

8. Système de détection selon la revendication 6, **caractérisé en ce que** ledit modulateur (15) est configuré pour former le signal acoustique modulé en réalisant un filtrage passe-bande sur le signal acoustique selon la bande de fréquences prédéterminée et en le multipliant par une fonction cosinus de fréquence centrale prédéterminée et de déphasage nul.

9. Système de détection selon la revendication 6, **caractérisé en ce que** la fréquence centrale déterminée est une valeur comprise entre 30kHz et 200kHz et de préférence égale à environ 100kHz, la bande de fréquence prédéterminée étant une valeur comprise entre 10kHz et 50kHz et de préférence égale à environ 20kHz, la fréquence de coupure étant d'environ 5kHz et la fréquence d'échantillonnage étant d'environ 10kHz.

10. Système de détection selon l'une quelconque des revendications précédentes, **caractérisé en ce que** l'installation électrique (7) comprend un ensemble d'éléments électriques équipés chacun d'un capteur spécifique permettant ainsi d'identifier l'élément électrique à l'endroit duquel l'arc électrique se produit.

11. Procédé de détection d'un arc électrique dans une installation électrique (7) équipée d'au moins un capteur (5) adapté à détecter des signaux acoustiques temporels produits par l'installation électrique, ledit procédé étant **caractérisé en ce qu'**il comporte une analyse de tout signal acoustique temporel en provenance dudit au moins un capteur en associant audit signal acoustique une mesure de parcimonie correspondante dont la valeur indique si ledit signal acoustique est une signature d'un arc électrique ou non, ladite analyse comportant une formation d'un signal échantillonné en échantillonnant ledit signal acoustique, une formation d'un signal comprimé en comprimant le signal échantillonné, et une reconstruction du signal échantillonné à partir dudit signal comprimé.

**Patentansprüche**

1. System zum Erfassen eines Lichtbogens in einer elektrischen Anlage (7), die mit zumindest einem Sensor (5) ausgestattet ist, der geeignet ist, zeitliche akustische Signale zu erfassen, die von der elektrischen Anlage (7) erzeugt werden, wobei das System **dadurch gekennzeichnet ist, dass** es eine Analysevorrichtung (3) enthält, die dazu ausgelegt ist, jedes zeitliche akustische Signal (S) zu analysieren, das von dem zumindest einen Sensor (5) kommt, indem sie dem akustischen Signal ein entsprechendes Ausdünnungsmaß (m) zuordnet, dessen Wert angibt, ob das akustische Signal eine Signatur eines Lichtbogens ist oder nicht, wobei die Analysevorrichtung dazu ausgelegt ist, das Ausdünnungsmaß zu bestimmen, indem sie das akustische Signal abtastet, um ein abgetastetes Signal zu bilden, das abgetastete Signal komprimiert, um ein komprimiertes Signal zu bilden, und das abgetastete Signal aus dem komprimierten Signal rekonstruiert.

2. Erfassungssystem nach Anspruch 1, **dadurch gekennzeichnet, dass** die Analysevorrichtung (3) enthält:

   - eine Vorverarbeitungsschaltung (11), die dazu ausgelegt ist, das zeitliche akustische Signal (S) in ein abgetastetes Signal $f$ von vorbestimmter Dimension N und ausgedrückt in einer Zeitbasis zu transformieren,
   - einen Prozessor (21), der dazu ausgelegt ist, das Ausdünnungsmaß des akustischen Signals durch Berechnen einer Ausdünnungswahrscheinlichkeit des entsprechenden abgetasteten Signals $f$ zu bestimmen und eine Überschreitung eines vorbestimmten Schwellenwerts durch die Ausdünnungswahrscheinlichkeit zu erkennen, wobei die Überschreitung für die Signatur eines Lichtbogens repräsentativ ist.

3. Erfassungssystem nach Anspruch 2, **dadurch gekennzeichnet, dass** der Prozessor (21) dazu ausgelegt ist,

   - das abgetastete Signal $f$ iterativ zu komprimieren, indem es bei jeder aktuellen Iteration mit einer bei jeder Iteration unterschiedlichen Erfassungszufallsmatrix $\phi$ multipliziert wird, wodurch ein aktuelles unterabgetastetes Signal $y$ der Dimension M mit M < N gebildet wird,
   - aus dem aktuellen unterabgetasteten Signal $y$ ein aktuelles Rekonstruktionsabtastsignal $\hat{f}$ zu berechnen, indem eine Lösung gesucht wird, die einen vorgegebenen Betrag $I_1$ minimiert, welcher die Ausdünnung des Abtastsignals bemisst,
   - eine vorgegebene Anzahl $k$ aktueller geschätzter Zeitpositionen $\hat{p}_1,...,\hat{p}_k$ der stärksten Amplituden des Rekonstruktionsabtastsignals $\hat{f}$ zu identifizieren,
   - die Ausdünnungswahrscheinlichkeit $P_L$ des abgetasteten Signals $f$ durch Berechnen des Anteils der Anzahl von Iterationen, in denen die geschätzten Zeitpositionen $\hat{p}_1, ..., \hat{p}_k$ der höchsten Amplituden des Rekonstruktionsabtastsignals $\hat{f}$ mit den tatsächlichen Zeitpositionen $p_1, ..., p_k$ der höchsten Amplituden des abgetasteten Signals $f$ übereinstimmen, zu bestimmen,
   - die Ausdünnungswahrscheinlichkeit $P_L$ mit dem vorgegebenen Schwellenwert zu vergleichen, wobei das akustische Signal eine Signatur eines Lichtbogens ist, wenn die Ausdünnungswahrscheinlichkeit $P_L$ größer als der vorgegebene Schwellenwert ist.

4. Erfassungssystem nach Anspruch 3, **dadurch gekennzeichnet, dass** die vorbestimmte Zahl $k$ gleich eins ist und dass der Prozessor (21) dazu ausgelegt ist,

   - eine aktuelle geschätzte Zeitposition der maximalen Amplitude des Rekonstruktionsabtastsignals $\hat{f}$ zu identifizieren, und
   - die Ausdünnungswahrscheinlichkeit $P_L$ des abgetasteten Signals $f$ durch Berechnen des Anteils der Anzahl von Iterationen, in denen jede geschätzte Zeitposition der maximalen Amplitude des Rekonstruktionsabtastsignals $\hat{f}$ mit der tatsächlichen Zeitposition der maximalen Amplitude des abgetasteten Signals $f$ übereinstimmt, zu bestimmen.

5. Erfassungssystem nach Anspruch 3 oder 4, **dadurch gekennzeichnet, dass** der Prozessor (21) ferner dazu ausgelegt ist, das abgetastete Signal $f$ vor seiner Komprimierung in einer anderen Orthonormalbasis, in der es ausgedünnt ist, unter Verwendung einer Übergangsmatrix $\psi$ auszudrücken.

6. Erfassungssystem nach einem der Ansprüche 2 bis 5, **dadurch gekennzeichnet, dass** die Vorverarbeitungsschaltung (11) enthält:

   - einen Modulator (15), der dazu ausgelegt ist, ein moduliertes akustisches Signal zu bilden, indem er das akustische Signal bei einer vorgegebenen Mittenfrequenz und einem vorgegebenen Frequenzband moduliert,
- ein Tiefpassfilter (17), das dazu ausgelegt ist, ein gefiltertes akustisches Signal durch Tiefpassfilterung bei einer vorbestimmten Grenzfrequenz an dem modulierten akustischen Signal zu bilden, und
- einen Abtaster (19), der dazu ausgelegt ist, das gefilterte akustische Signal mit einer Abtastfrequenz abzutasten, die größer oder gleich dem Zweifachen der Grenzfrequenz ist, wodurch das abgetastete Signal *f* gebildet wird.

**7.** Erfassungssystem nach Anspruch 6, **dadurch gekennzeichnet, dass** der zumindest eine Sensor (5) so ausgewählt ist, dass sein Verstärkungsmuster eine maximale Verstärkung in dem vorgegebenen Frequenzband aufweist.

**8.** Erfassungssystem nach Anspruch 6, **dadurch gekennzeichnet, dass** der Modulator (15) dazu ausgelegt ist, das modulierte akustische Signal durch Bandpassfilterung des akustischen Signals bei dem vorbestimmten Frequenzband und durch Multiplikation mit einer Kosinusfunktion mit vorbestimmter Mittenfrequenz und Nullphasenverschiebung zu bilden.

**9.** Erfassungssystem nach Anspruch 6, **dadurch gekennzeichnet, dass** die bestimmte Mittenfrequenz ein Wert zwischen 30 kHz und 200 kHz und vorzugsweise gleich etwa 100 kHz ist, das vorgegebene Frequenzband ein Wert zwischen 10 kHz und 50 kHz und vorzugsweise gleich etwa 20 kHz ist, die Grenzfrequenz etwa 5 kHz und die Abtastfrequenz etwa 10 kHz beträgt.

**10.** Erfassungssystem nach einem der vorhergehenden Ansprüche, **dadurch gekennzeichnet, dass** die elektrische Anlage (7) eine Anordnung von elektrischen Elementen enthält, die jeweils mit einem spezifischen Sensor ausgestattet sind, wodurch es möglich ist, dasjenige elektrische Element zu identifizieren, an dessen Stelle der Lichtbogen auftritt.

**11.** Verfahren zum Erfassen eines Lichtbogens in einer elektrischen Anlage (7), die mit zumindest einem Sensor (5) ausgestattet ist, der geeignet ist, zeitliche akustische Signale zu erfassen, die von der elektrischen Anlage erzeugt werden, wobei das Verfahren **dadurch gekennzeichnet ist, dass** es eine Analyse jedes zeitlichen akustischen Signals umfasst, das von dem zumindest einen Sensor kommt, indem dem akustischen Signal ein entsprechendes Ausdünnungsmaß zugeordnet wird, dessen Wert angibt, ob das akustische Signal eine Signatur eines Lichtbogens ist oder nicht, wobei die Analyse das Bilden eines abgetasteten Signals durch Abtasten des akustischen Signals, das Bilden eines komprimierten Signals durch Komprimieren des abgetasteten Signals und das Rekonstruieren des abgetasteten Signals aus dem komprimierten Signal umfasst.

**Claims**

**1.** System for detecting an electric arc in an electrical installation (7) equipped with at least one sensor (5) capable of detecting temporal acoustic signals produced by the electrical installation (7), said system being **characterised in that** it comprises an analysis device (3) configured to analyse any temporal acoustic signal (S) coming from said one or more sensors (5) by associating with said acoustic signal a corresponding parsimony measurement (m) whose value indicates whether or not the acoustic signal is a signature of an electric arc, where the analysis device is configured to determine said parsimony measurement by sampling said acoustic signal to form a sampled signal, by compressing the sampled signal to form a compressed signal and by reconstructing the sampled signal from said compressed signal.

**2.** Detection system according to claim 1, **characterised in that** the analysis device (3) comprises:

- a pre-conditioning circuit (11) configured to transform said temporal acoustic signal (S) into a sampled signal *f* of predetermined dimension N and which is expressed in a temporal base,
- a processor (21) configured to determine the parsimony measurement of said acoustic signal by calculating a parsimony probability of the corresponding sampled signal *f*, and to detect whether said parsimony probability exceeds a predetermined threshold value, where said exceeding of the threshold value is representative of a signature of an electric arc.

**3.** Detection system according to claim 2, **characterised in that** said processor (21) is configured to:

- compress the sampled signal *f* iteratively by multiplying it at each current iteration by a random acquisition matrix $\phi$ which differs at each iteration, forming a current sub-sampled signal *y* of dimension *M* where *M < N*,
- calculate, from the current sub-sampled signal *y*, a current reconstruction sampled signal $\hat{f}$ by seeking a solution which minimises a predetermined norm $l_1$ which measures the parsimony of the sampled signal,
- identify a predetermined number *k* of current estimated temporal positions $\hat{p}_1, ..., \hat{p}_k$ of the greatest amplitudes of the sampled reconstruction signal $\hat{f}$,
- determine the parsimony probability $P_L$ of said sampled signal *f* by calculating the proportion of the number of iterations during which the estimated temporal positions $\hat{p}_1,...,\hat{p}_k$ of the greatest amplitudes of the sampled reconstruction signal $\hat{f}$ are concordant with the true temporal positions $p_1,...,p_k$ of the greatest amplitudes of the sampled signal $f$,

- compare said parsimony probability $P_L$ with said predetermined threshold value, said acoustic signal being a signature of an electric arc if the parsimony probability $P_L$ is greater than said predetermined threshold value.

4. Detection system according to claim 3, **characterised in that** said predetermined number k is equal to one and **in that** said processor (21) is configured to:

- identify a current estimated temporal position of the maximum amplitude of the sampled reconstruction signal $\hat{f}$, and
- determine the parsimony probability $P_L$ of said sampled signal $f$ by calculating the proportion of the number of iterations during which each estimated temporal position of the maximum amplitude of the sampled reconstruction signal $\hat{f}$ is concordant with the true temporal position of the maximum amplitude of the sampled signal $f$.

5. Detection system according claim 3, **characterised in that** said processor (21) is moreover configured to express the sampled signal $f$ before it is compressed in another orthonormal base in which it is parsimonious, by using a transfer matrix .

6. Detection system according to claim 2, **characterised in that** the pre-conditioning circuit (11) comprises:

- a modulator (15), configured to form a modulated acoustic signal by modulating said acoustic signal according to a predetermined central frequency and a predetermined frequency band,
- a low-pass filter (17) configured to form a filtered acoustic signal by performing low-pass filtering according to a predetermined cut-off frequency on said modulated acoustic signal, and
- a sampler (19), configured to sample the filtered acoustic signal at a sampling frequency equal to or greater than double the cut-off frequency thus forming said sampled signal $f$.

7. Detection system according to claim 6, **characterised in that** said one or more sensors (5) is selected such that its gain diagram exhibits a maximum gain within the predetermined frequency band.

8. Detection system according to claim 6, **characterised in that** said modulator (15) is configured to form the modulated acoustic signal by performing band-pass filtering on the acoustic signal according to the predetermined frequency band and by multiplying it by a cosine function of the predetermined central frequency and zero phase-shift.

9. Detection system according to claim 6, **characterised in that** the determined central frequency has a value between 30kHz and 200kHz and preferably equal to about 100kHz, where the predetermined frequency band has a value between 10kHz and 50kHz and preferably equal to about 20kHz, where the cut-off frequency is about 5kHz and where the sampling frequency is about 10kHz.

10. Detection system according to claim 1, **characterised in that** the electrical installation (7) comprises a set of electrical elements, each equipped with a specific sensor thus allowing the electrical element at the location at which the electric arc is produced to be identified.

11. Method for detecting an electric arc in an electrical installation (7) equipped with at least one sensor (5) capable of detecting temporal acoustic signals produced by the electrical installation, said method being **characterised in that** it comprises an analysis of any temporal acoustic signal coming from said one or more sensors by associating with said acoustic signal a corresponding parsimony measurement whose value indicates whether or not the acoustic signal is a signature of an electric arc, where said analysis comprises a formation of a sampled signal by sampling of said acoustic signal, a formation of a compressed signal by compressing the sampled signal, and a reconstruction of the sampled signal from said compressed signal.

FIG.1

FIG.2

FIG.3A

FIG.3B

$y = \phi\, f$ — E1

$\hat{f}$ — E2

$\hat{p}_1,\ \ldots,\ \hat{p}_k$ — E3

$\left(\hat{p}_1,\ldots,\hat{p}_k\right) \overset{?}{=} \left(p_1,\ldots,p_k\right)$ — E4

$C = C+1$ — E5

FIG.4A

$n \overset{?}{=} L$ — E6

$P_L$ — E7

$P_L > V_o$ — E8

— E9

END — E10

FIG.4B

- $y = \phi f$ — E21
- $\hat{f}$ — E22
- $\hat{p}_{L\,max}$ — E23
- $\hat{p}_{L\,max} \overset{?}{=} p_{L\,max}$ — E24
- $C = C+1$ — E25
- $n \overset{?}{=} L$ — E26
- $P_{L\,max}$ — E27
- $P_{L\,max} > V_o$ — E28
- E29
- END — E30

FIG.5A

FIG.5B

FIG.6A

FIG.6B

FIG.7A

FIG.7B

FIG.8A

FIG.8B

FIG.9

$f = \psi x$ — E30

$y = \phi\psi x$ — E31

$\hat{x}, \hat{f}$ — E32

$\hat{p}_1, \ldots, \hat{p}_k$ — E33

$(\hat{p}_1, \ldots, \hat{p}_k) \overset{?}{=} (p_1, \ldots, p_k)$ — E34

$C = C + 1$ — E35

$n \overset{?}{=} L$ — E36

$P_L$ — E37

$P_L > V_o$ — E38

E39

END — E40

FIG.10

EP 3 232 212 B1

**RÉFÉRENCES CITÉES DANS LA DESCRIPTION**

**Documents brevets cités dans la description**

- FR 3015045